# EUROPEAN PATENT APPLICATION

(11) **EP 4 823 265 A1**
(43) Date of publication of application: **14.10.2026**
(21) Application number: 24916661.2
(22) Date of filing: 13.12.2024
(51) Int. Cl.: H05K 9/00

(54) **ELECTROMAGNETIC SHIELDING COVER AND STATION**

(30) Priority: 12.01.2024 CN 202410058132
(71) Applicant: Huawei Technologies Co., Ltd., Shenzhen, Guangdong 518129 (CN)
(72) Inventor: FENG, Xin, Shenzhen, Guangdong 518129 (CN); ZHU, Zelin, Shenzhen, Guangdong 518129 (CN); CAI, Meng, Shenzhen, Guangdong 518129 (CN); MA, Chuanhui, Shenzhen, Guangdong 518129 (CN)
(74) Representative: Gill Jennings & Every LLP
(86) International application number: PCT/CN2024/139224
(87) International publication number: WO 2025/148614

(57) **Abstract**

An electromagnetic shielding cover is provided. The electromagnetic shielding cover is disposed on a first side face of a base station module. The electromagnetic shielding cover is perpendicular to an antenna platform of the base station module. The electromagnetic shielding cover extends in a direction perpendicular to the antenna platform of the base station module. A height of the electromagnetic shielding cover exceeds a thickness of the base station module by a first height. Energy radiated by the base station module includes energy of a front upper sidelobe. The electromagnetic shielding cover is configured to shield the energy of the front upper sidelobe. The electromagnetic shielding cover is disposed on the first side face of the base station module, is perpendicular to the antenna platform of the base station module, and extends in the direction perpendicular to the antenna platform of the base station module. Because the height of the electromagnetic shielding cover exceeds that of the base station module, the electromagnetic shielding cover can shield the energy of the front upper sidelobe of the base station module.

## Description

This application claims priority to China Patent Application No. 202410058132.3, filed with the China National Intellectual Property Administration on January 12, 2024, and entitled "ELECTROMAGNETIC SHIELDING COVER AND SITE", which is incorporated herein by reference in its entirety.

### TECHNICAL FIELD

This application relates to the field of communication technologies, and in particular, to an electromagnetic shielding cover and a site.

### BACKGROUND

In mobile communication, there has been a continuous pursuit of a larger capacity, a higher rate, and a lower latency, which has driven ongoing generational evolution from 2G to 5G, 6G, and the like. A simplest and most direct way to increase the capacity and the rate is to increase bandwidth. For example, main frequency bands of 4G and earlier are sub-3 GHz frequency bands (below 3 GHz); and in the 5G era, new frequency bands such as 3.5 GHz, 4.9 GHz, and millimeter wavebands were introduced. With socioeconomic development, new mobile communication requirements are emerging, and future mobile communication will require introduction of more new spectrums resources. Among these, U6G (6.425 GHz to 7.125 GHz) is an important resource frequency band in the 2025 to 2030 timeframe, and is crucial for meeting new service requirements. However, spectrum resources are valuable, and the U6G frequency band is also an uplink frequency band for geosynchronous orbit (Geostationary Earth Orbit, GEO) satellites. Therefore, to deploy mobile communication base stations in the U6G frequency band, addressing interference from the base stations to satellites is a prerequisite.

To implement coexistence of U6G base stations and existing GEO satellite uplink services, hereinafter referred to as satellite coexistence, the International Telecommunication Union (International Telecommunication Union, ITU) has studied and defined upper hemisphere radiated power requirements to be satisfied by the base station. In the research, factors such as an interference threshold for satellite uplink, longitude and latitude of a satellite, beam coverage of the satellite, and deployment density of terrestrial base stations are mainly considered. Based on these factors, average equivalent isotropic radiated power (Effective Isolated Radiated Power, EIRP) limits that the base station needs to satisfy for respective elevation angle range of upper hemisphere are derived. These limits are collectively referred to as an EIRP mask. Because a main beam of the base station points to lower hemisphere, upper sidelobe radiation of the base station needs to be suppressed in order to satisfy the mask.

One of key technologies of 5G is the use of massive array antennas in base stations. This technology originates from radars, and a main feature thereof is the capability of beamforming. To improve detection sensitivity, radars need to reduce interference in other directions except the main beam. In this technology, an array antenna can suppress sidelobes through specific weighting. Typical low sidelobe weighting methods include amplitude weighting, Taylor weighting, and the like. However, using weighting methods to improve upper sidelobe suppression has at least three disadvantages. First, amplitude weighting causes EIRP loss. Second, Weighting poses high requirements on degrees of freedom of the array antenna. Third, the suppression capability of amplitude weighting is constrained by channel consistency.

### SUMMARY

This application discloses an electromagnetic shielding cover and a site, to improve a capability of suppressing upper sidelobe radiation of a base station.

According to a first aspect, an embodiment of this application provides an electromagnetic shielding cover. The electromagnetic shielding cover is disposed on a first side face of a base station module. The electromagnetic shielding cover is perpendicular to an antenna platform of the base station module. The electromagnetic shielding cover extends in a direction perpendicular to the antenna platform of the base station module. A height of the electromagnetic shielding cover exceeds a thickness of the base station module by a first height. Energy radiated by the base station module includes energy of a front upper sidelobe. The electromagnetic shielding cover is configured to shield the energy of the front upper sidelobe.

In this example, the electromagnetic shielding cover is disposed on the first side face of the base station module, is perpendicular to the antenna platform of the base station module, and extends in the direction perpendicular to the antenna platform of the base station module. Because the height of the electromagnetic shielding cover exceeds that of the base station module, the electromagnetic shielding cover can shield the energy of the front upper sidelobe of the base station module.

In a possible implementation, the first height is related to a height of the base station module.

In a possible implementation, the electromagnetic shielding cover is further disposed in parallel with a rear face of the base station module. The energy radiated by the base station module further includes energy of a rear upper sidelobe. The electromagnetic shielding cover is further configured to shield the energy of the rear upper sidelobe.

In this example, a portion of the electromagnetic shielding cover is disposed on the first side face of the base station module, and another portion is disposed in parallel with the rear face of the base station module. This can not only shield the energy of the front upper sidelobe of the base station module, but also shield the energy of the rear upper sidelobe of the base station module.

In a possible implementation, the electromagnetic shielding cover is further disposed on a second side face and a third side face of the base station module. The second side face and the third side face are separately connected to the first side face. The energy radiated by the base station module further includes energy of an oblique upper sidelobe. The electromagnetic shielding cover is further configured to shield the energy of the oblique upper sidelobe.

In this example, a portion of the electromagnetic shielding cover is disposed on the first side face of the base station module, and another portion is disposed in parallel with the rear face of the base station module. This can not only shield the energy of the front upper sidelobe of the base station module, but also shield the energy of the rear upper sidelobe of the base station module. The electromagnetic shielding cover is further disposed on the second side face and the third side face of the base station module, to shield the energy of the oblique upper sidelobe.

In a possible implementation, the electromagnetic shielding cover includes a first portion, a second portion, and a third portion, and the first portion, the second portion, and the third portion are respectively configured to shield the energy of the front upper sidelobe, the energy of the rear upper sidelobe, and the energy of the oblique upper sidelobe.

In a possible implementation, the first portion is umbrella-shaped or annular shaped.

In a possible implementation, an outer edge of the first portion is arc-shaped.

In a possible implementation, a wave-absorbing material or an electromagnetic band gap EBG structure is disposed on the outer edge of the first portion, to suppress a surface wave of the base station module.

In a possible implementation, a size of the second portion is greater than or equal to a size of the base station module.

In a possible implementation, the third portion has a concave curved shape.

In a possible implementation, the electromagnetic shielding cover has a metal mesh structure, and a grid size of the metal mesh is a quarter wavelength. Alternatively, the electromagnetic shielding cover is made based on a frequency selective surface FSS, and the FSS has a stopband covering a U6G frequency band.

In a possible implementation, the electromagnetic shielding cover may have a specific downtilt angle. Such a downtilt design can reduce an extension length.

According to a second aspect, an embodiment of this application provides an electromagnetic shielding cover. The electromagnetic shielding cover is umbrella-shaped. The electromagnetic shielding cover is configured to shield energy of an upper sidelobe of at least one base station module.

According to a third aspect, an embodiment of this application provides a site, including any possible electromagnetic shielding cover in the first aspect or any possible electromagnetic shielding cover in the second aspect, and at least one base station module.

It may be understood that for beneficial effects that can be achieved by the electromagnetic shielding cover in the second aspect and the site in the third aspect, refer to corresponding beneficial effects of the electromagnetic shielding cover. Details are not described herein again.

### BRIEF DESCRIPTION OF DRAWINGS

The following describes the accompanying drawings used in embodiments of this application.
FIG. 1 is a diagram of an electromagnetic shielding cover according to an embodiment of this application;
FIG. 2 is a diagram of a base station module according to an embodiment of this application;
FIG. 3a is a three-dimensional diagram of another electromagnetic shielding cover according to an embodiment of this application;
FIG. 3b is a schematic plan view of another electromagnetic shielding cover according to an embodiment of this application;
FIG. 4a is a three-dimensional diagram of still another electromagnetic shielding cover according to an embodiment of this application;
FIG. 4b is a schematic sectional view of another electromagnetic shielding cover according to an embodiment of this application;
FIG. 5 is a diagram of distribution of upper sidelobe angle regions of a base station module according to an embodiment of this application;
FIG. 6a is a top view of still another electromagnetic shielding cover according to an embodiment of this application;
FIG. 6b is a side view of still another electromagnetic shielding cover according to an embodiment of this application;
FIG. 6c is a top view of still another electromagnetic shielding cover according to an embodiment of this application;
FIG. 7 to FIG. 13b(B) are diagrams of different electromagnetic shielding covers according to embodiments of this application;
FIG. 14 is a diagram of still another electromagnetic shielding cover according to an embodiment of this application;
FIG. 15 is a diagram of still another electromagnetic shielding cover according to an embodiment of this application;
FIG. 16a(A) to FIG. 16a(C) are comparison diagrams of suppression degrees when a driving relationship is one-drive-three and heights of an upper sidelobe shielding cover are respectively 0H, 1H, and 2H according to an embodiment of this application;
FIG. 16b(A) and FIG. 16b(B) are comparison diagrams of impact of an opening angle of a side shielding cover on horizontal scanning of a base station according to an embodiment of this application;
FIG. 16c is a diagram of a mesh structure according to an embodiment of this application;
FIG. 16d is a diagram of a scenario according to an embodiment of this application; and
FIG. 17 is a diagram of an application according to an embodiment of this application.

### DESCRIPTION OF EMBODIMENTS

The following describes embodiments of this application with reference to the accompanying drawings in embodiments of this application. Terms used in implementations of embodiments of this application are merely used to explain specific embodiments of this application, and are not intended to limit this application.

For ease of understanding, the following describes a part of concepts related to embodiments of this application for reference by using examples. Details are as follows.

Satellite coexistence means that a terrestrial mobile communication service and a satellite uplink service coexist in an overlapping frequency band. The two services do not interfere with each other, or interference is less than a threshold. Both the services can operate normally.

Upper sidelobe suppression: An array antenna can perform beamforming, so that energy of the array antenna is mainly concentrated in a main beam direction, but there is still a small amount of energy in other directions. From a perspective of an antenna pattern, radiation is divided into a main lobe and sidelobes. A size of the main lobe is a quantitative description of the radiated energy in the main beam direction, and sizes of the sidelobes are quantitative descriptions of the radiated energy in the other directions. A sidelobe in upper hemisphere is referred to as an upper sidelobe. Upper sidelobe suppression means that the radiated energy of the upper sidelobe needs to be suppressed to reduce interference to the upper hemisphere.

Array antenna weighting means exciting different antenna units of an array antenna with signals of different amplitudes and phases, so that excitation weights satisfy specific distribution, to obtain a desired beamforming effect of a pattern.

Antenna platform: In communication, the antenna platform in base station site survey is a platform on which an antenna is located. Measurement of external interference and deployment of feeder lines are both performed on the antenna platform. In embodiments of this application, a face opposite to the antenna platform is referred to as a rear surface (refer to the following descriptions, and details are not described herein again).

The foregoing example descriptions of the concepts may be applied in the following embodiments.

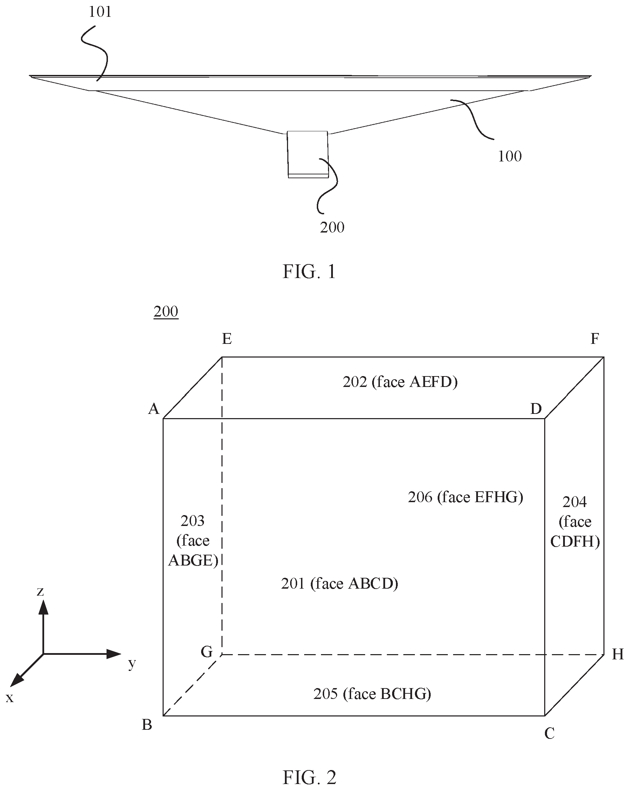

The following details structures in embodiments of this application with reference to the accompanying drawings. FIG. 1 is a diagram of an electromagnetic shielding cover 100 to which an embodiment of this application is applicable. As shown in FIG. 1, the electromagnetic shielding cover 100 is disposed on a side of a base station module 200. Energy radiated by the base station module 200 includes energy of a front upper sidelobe. The electromagnetic shielding cover 100 is configured to shield the energy of the front upper sidelobe.

FIG. 2 is a diagram of the base station module 200 according to an embodiment of this application. The base station module 200 includes an antenna platform 201 (that is, a face ABCD shown in FIG. 2), a first side face 202 (that is, a face ADEF shown in FIG. 2), a second side face 203 (that is, a face ABGE shown in FIG. 2), a third side face 204 (that is, a face CDFH shown in FIG. 2), a fourth side face 205 (that is, a face BCHG shown in FIG. 2), and a rear face 206 (that is, a face EFHG shown in FIG. 2). This example is described by using a cuboid as an example, and another regular shape, an irregular shape, or the like may alternatively be used. This is not limited in this solution.

With reference to FIG. 1, the electromagnetic shielding cover 100 is disposed on the first side face 202 of the base station module 200. The electromagnetic shielding cover 100 is perpendicular to the antenna platform 201 of the base station module 200. The electromagnetic shielding cover 100 extends in a direction perpendicular to the antenna platform 201 of the base station module, that is, extends in a direction of the first side face 202 of the base station module 200. A height (which may also be referred to as a length) of the electromagnetic shielding cover 100 is greater than a thickness (which may be, for example, a width of the first side face 202, where the width may be a length of a side AE when the first side face 202 is a rectangle) of the base station module by a first height.

It should be noted that in this embodiment of this application, the height of the electromagnetic shielding cover is a length of a portion of the electromagnetic shielding cover that shields the energy of the front upper sidelobe, that is, a length in the direction perpendicular to the antenna platform of the base station module. For example, the direction perpendicular to the antenna platform of the base station module is a direction x shown in FIG. 2.

In a possible implementation, the first height is related to a height (for example, a length of a side AB in FIG. 2) of the base station module. For example, the first height is 0.5 to 1 times the height H of the base station module. Certainly, the first height may alternatively be another value. This is not limited in this solution. The farther the electromagnetic shielding cover extends, the stronger a capability of suppressing energy radiated upward by the base station module.

In a possible implementation, a front edge (also referred to as an outer edge) 101 of the electromagnetic shielding cover may be in an arc shape. Certainly, the outer edge may alternatively be in another shape. This is not limited in this solution.

In a possible implementation, the electromagnetic shielding cover may have a specific downtilt angle. Such a downtilt design can reduce an extension length.

In a possible implementation, a wave-absorbing material is disposed on the outer edge 101 of the electromagnetic shielding cover. This can further improve the capability of suppressing the energy radiated upward by the base station module.

Alternatively, an electromagnetic band gap (Electronic Band Gap, EBG) structure that can suppress surface wave propagation is disposed on the outer edge 101 of the electromagnetic shielding cover.

In this example, the electromagnetic shielding cover is disposed on the first side face of the base station module, is perpendicular to the antenna platform of the base station module, and extends in the direction perpendicular to the antenna platform of the base station module. Because the height of the electromagnetic shielding cover exceeds that of the base station module, the electromagnetic shielding cover can shield the energy of the front upper sidelobe of the base station module.

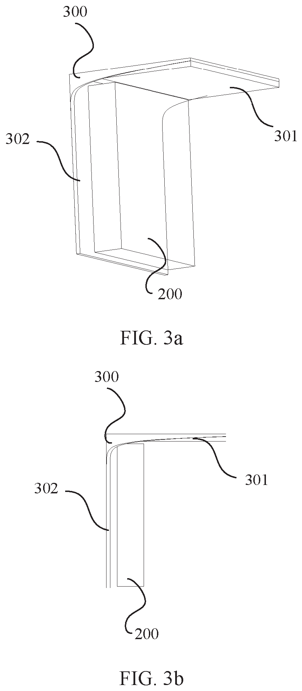

FIG. 3a and FIG. 3b each are a diagram of another electromagnetic shielding cover 300 to which an embodiment of this application is applicable. With reference to FIG. 2, a portion 301 of the electromagnetic shielding cover 300 is disposed on the first side face 202 of the base station module 200, the portion 301 of the electromagnetic shielding cover 300 is perpendicular to the antenna platform 201 of the base station module 200, the portion 301 of the electromagnetic shielding cover 300 extends in a direction perpendicular to the antenna platform 201 of the base station module, and a height of the portion 301 of the electromagnetic shielding cover 300 is greater than a thickness (for example, a length of a side AE) of the base station module by a first height. Another portion 302 of the electromagnetic shielding cover 300 is disposed in parallel with the rear face 206 of the base station module 200. Energy radiated by the base station module 200 includes energy of a front upper sidelobe and energy of a rear upper sidelobe. The electromagnetic shielding cover 300 is configured to shield the energy of the front upper sidelobe and the energy of the rear upper sidelobe. For example, the portion 301 of the electromagnetic shielding cover 300 is configured to shield the energy of the front upper sidelobe, and the another portion 302 of the electromagnetic shielding cover 300 is configured to shield the energy of the rear upper sidelobe.

In a possible implementation, a size of a portion (that is, the another portion 302 of the electromagnetic shielding cover 300) of the electromagnetic shielding cover that is disposed in parallel with the rear face 206 of the base station module 200 is greater than or equal to a size of the base station module, for example, may be slightly greater than that of the rear face 206 of the base station module. In this way, energy radiation of the rear upper sidelobe can be blocked.

In a possible implementation, the first height is related to a height (for example, a length of a side AB in FIG. 2) of the base station module. For descriptions of this part, refer to the descriptions of the embodiment shown in FIG. 1. Details are not described herein again.

In a possible implementation, an outer edge of the portion 301 of the electromagnetic shielding cover may be in an arc shape.

In a possible implementation, the portion 301 of the electromagnetic shielding cover may have a specific downtilt angle.

In a possible implementation, a wave-absorbing material is disposed on the outer edge of the portion 301 of the electromagnetic shielding cover. This can further improve a capability of suppressing energy radiated upward by the base station module.

Alternatively, an electromagnetic band gap EBG structure that can suppress surface wave propagation is disposed on the outer edge of the portion 301 of the electromagnetic shielding cover.

In this example, a portion of the electromagnetic shielding cover is disposed on the first side face of the base station module, and another portion is disposed in parallel with the rear face of the base station module. This can not only shield the energy of the front upper sidelobe of the base station module, but also shield the energy of the rear upper sidelobe of the base station module.

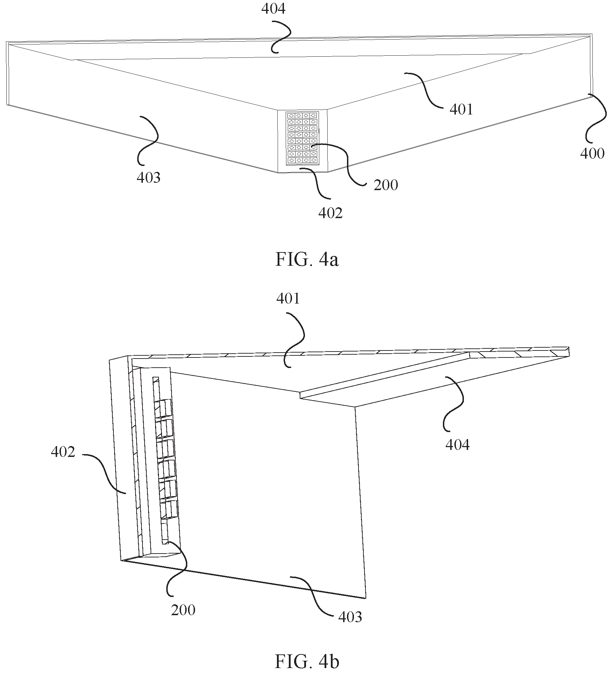

FIG. 4a and FIG. 4b each are a diagram of still another electromagnetic shielding cover 400 to which an embodiment of this application is applicable. With reference to FIG. 2, the electromagnetic shielding cover 400 is disposed on the first side face 202 of the base station module 200, the electromagnetic shielding cover 400 is perpendicular to the antenna platform 201 of the base station module 200, the electromagnetic shielding cover 400 extends in a direction perpendicular to the antenna platform 201 of the base station module, and a height of the electromagnetic shielding cover 400 is greater than a thickness (for example, a length of a side AE) of the base station module by a first height. The electromagnetic shielding cover 400 is further disposed in parallel with the rear face 206 of the base station module 200. In addition, the electromagnetic shielding cover 400 is further disposed on the second side face 203 and the third side face 204 of the base station module 200, and the second side face 203 and the third side face 204 are separately connected to the first side face 202. Energy radiated by the base station module 200 includes energy of a front upper sidelobe, energy of a rear upper sidelobe, and energy of an oblique upper sidelobe. The electromagnetic shielding cover 400 is configured to shield the energy of the front upper sidelobe, the energy of the rear upper sidelobe, and the energy of the oblique upper sidelobe.

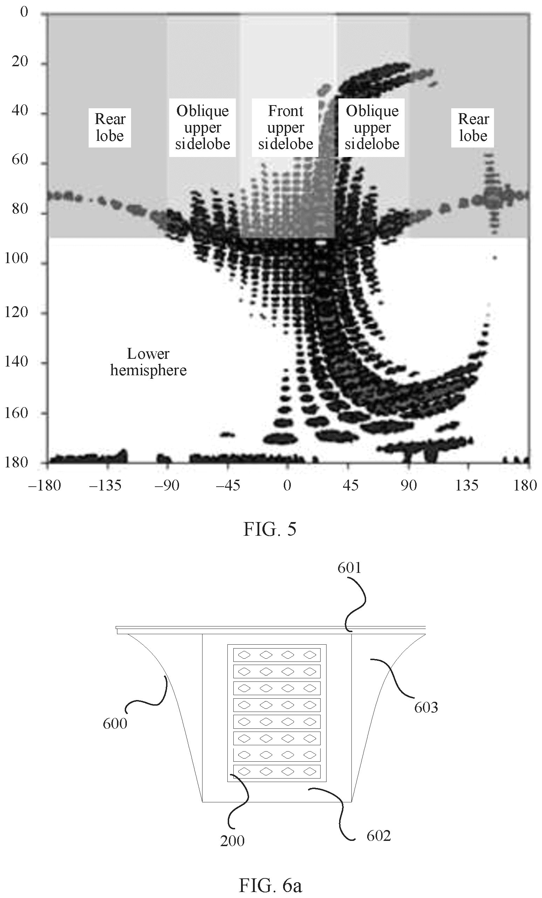

For example, the electromagnetic shielding cover 400 includes a first portion (an upper sidelobe shielding cover) 401, a second portion (a rear lobe shielding cover) 402, and a third portion (a side shielding cover) 403. The electromagnetic shielding cover 400 may cooperate with one base station module 200. For example, the base station module 200 is disposed inside the electromagnetic shielding cover 400. Most energy radiated upward by the base station module 200 is physically blocked by the electromagnetic shielding cover 400. For example, FIG. 5 is a diagram of distribution of upper sidelobe angle regions corresponding to the base station module. Radiation in corresponding upper hemisphere may include the front upper sidelobe, and further includes the oblique upper sidelobe and the rear upper sidelobe. In other words, the energy radiated by the base station module 200 includes the energy of the front upper sidelobe, the energy of the rear upper sidelobe, and the energy of the oblique upper sidelobe. Correspondingly, the first portion 401 of the electromagnetic shielding cover 400 is configured to shield the energy of the front upper sidelobe, the second portion 402 of the electromagnetic shielding cover 400 is configured to shield the energy of the rear upper sidelobe, and the third portion 403 of the electromagnetic shielding cover 400 is configured to shield the energy of the oblique upper sidelobe.

In a possible implementation, an outer edge of the first portion 401 of the electromagnetic shielding cover 400 may be in an arc shape.

In a possible implementation, as shown in FIG. 4a, a wave-absorbing material 404 or an electromagnetic band gap EBG structure 404 that can suppress surface wave propagation is disposed on the outer edge of the first portion 401 of the electromagnetic shielding cover 400. For descriptions of this part, refer to the descriptions of the embodiment shown in FIG. 1. Details are not described herein again.

In a possible implementation, an outer edge of the third portion 403 of the electromagnetic shielding cover 400 has a concave curved shape. Certainly, the outer edge may alternatively be in another shape. This is not limited in this solution.

In a possible implementation, the first portion 401 of the electromagnetic shielding cover 400 may have a specific downtilt angle.

In a possible implementation, a size of the second portion 402 of the electromagnetic shielding cover 400 is greater than or equal to a size of the base station module 200, for example, may be slightly greater than that of the rear face 206 of the base station module.

For descriptions of this part, refer to the descriptions of the embodiment shown in FIG. 1. Details are not described herein again.

The electromagnetic shielding cover may be referred to as a gamma (Γ)-shaped antenna-aperture-level electromagnetic shielding cover, or referred to as a Γ shielding cover or the like.

In a possible implementation, the third portion of the electromagnetic shielding cover is connected to a corner between the first portion and the second portion.

In a possible implementation, a material of the electromagnetic shielding cover may be at least one of a metal plate, metalized plastic, a hollowed-out metal plate, a metal mesh, or the like.

Optionally, the material of the electromagnetic shielding cover is the metal mesh, and a grid size of the metal mesh is a preset size. The metal mesh can shield a signal in a U6G frequency band. For example, a good shielding effect can be achieved when a grid spacing of the metal mesh is less than a quarter wavelength.

In this example, a portion of the electromagnetic shielding cover is disposed on the first side face of the base station module, and another portion is disposed in parallel with the rear face of the base station module. This can not only shield the energy of the front upper sidelobe of the base station module, but also shield the energy of the rear upper sidelobe of the base station module. The electromagnetic shielding cover is further disposed on the second side face and the third side face of the base station module, to shield the energy of the oblique upper sidelobe.

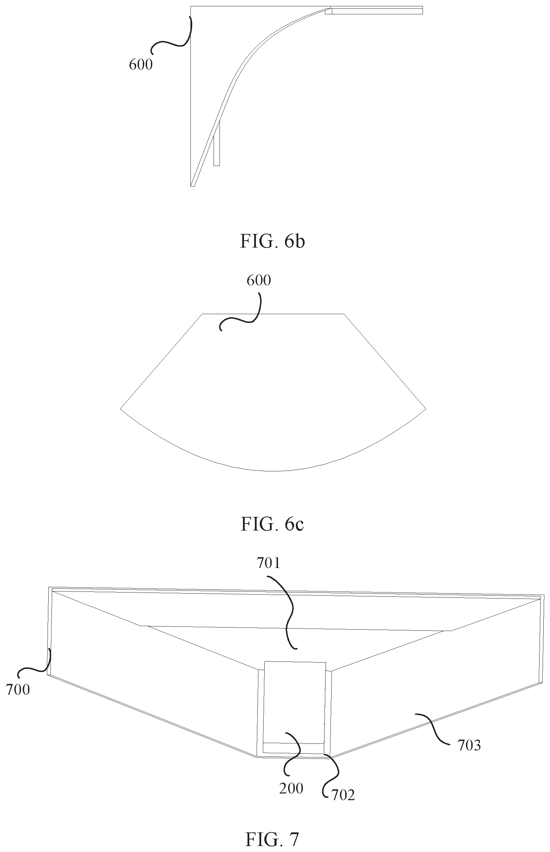

The following describes other shapes of the electromagnetic shielding cover provided in embodiments of this application. As shown in FIG. 6a to FIG. 6c, an electromagnetic shielding cover 600 includes a first portion 601, a second portion 602, and a third portion 603. Compared with the electromagnetic shielding cover 400 shown in FIG. 4a, the electromagnetic shielding cover 600 has a different size, shape, or the like.

For another example, as shown in FIG. 7, an electromagnetic shielding cover 700 includes a first portion 701, a second portion 702, and a third portion 703. Compared with the electromagnetic shielding cover 400 shown in FIG. 4a, the electromagnetic shielding cover 700 has a reduced length for the first portion 701.

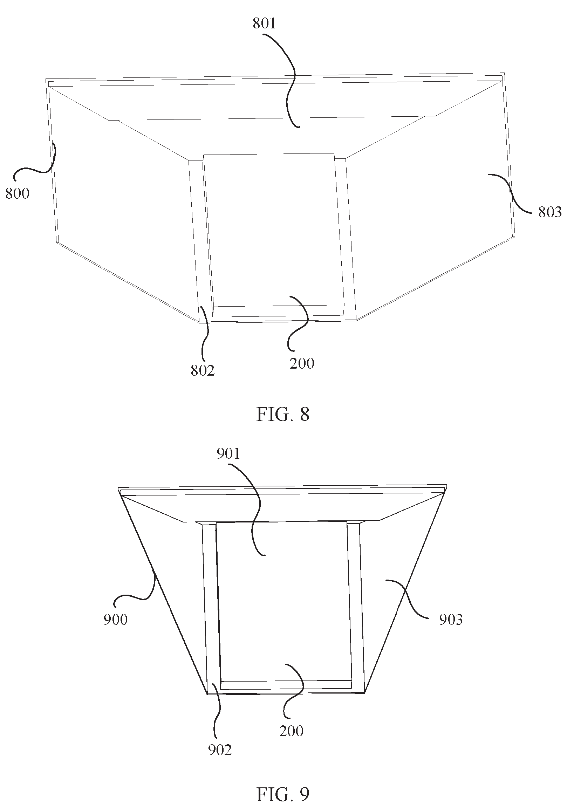

For another example, as shown in FIG. 8, an electromagnetic shielding cover 800 includes a first portion 801, a second portion 802, and a third portion 803. An angle between a side shielding cover (the third portion 803) and a rear shielding cover (the second portion 802) shown in FIG. 8 differs from that in FIG. 7 by 30° (where the figure is merely an example, the angle may be another angle, and this is not limited in this solution), and a size is further reduced.

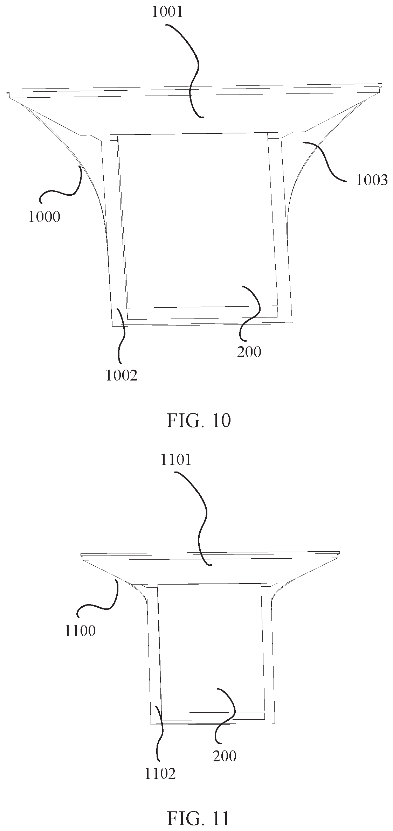

As shown in FIG. 9, an electromagnetic shielding cover 900 includes a first portion 901, a second portion 902, and a third portion 903. As shown in FIG. 10, an electromagnetic shielding cover 1000 includes a first portion 1001, a second portion 1002, and a third portion 1003. FIG. 9 and FIG. 10 are based on FIG. 8. A side shielding cover 903 in FIG. 9 is formed with a linear edge, and a side shielding cover 1003 in FIG. 10 is formed with a curved chamfer. This can restore a horizontal scanning capability of the base station module to ±60°.

As shown in FIG. 11, an electromagnetic shielding cover 1100 includes a first portion 1101 and a second portion 1102. In other words, the electromagnetic shielding cover in this example does not include a side shielding cover portion. The electromagnetic shielding cover 1100 is configured to shield energy of a front upper sidelobe and energy of a rear upper sidelobe.

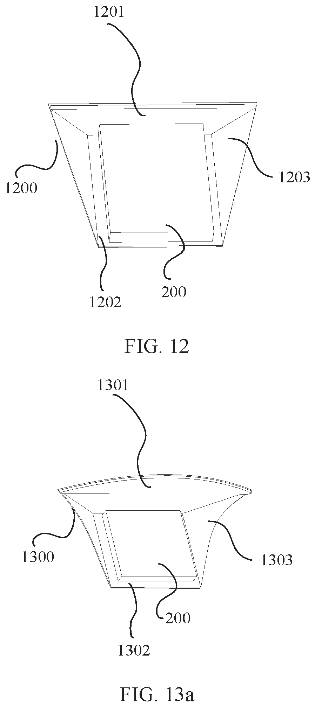

As shown in FIG. 12, an electromagnetic shielding cover 1200 includes a first portion 1201, a second portion 1202, and a third portion 1203. The electromagnetic shielding cover 1200 is further optimized in size. For example, a size of the first portion 1201 in FIG. 12 is less than that in FIG. 11, and the third portion 1203 and the like are additionally provided.

As shown in FIG. 13a, an electromagnetic shielding cover 1300 includes a first portion 1301, a second portion 1302, and a third portion 1303. Arc cutting is performed on an upper sidelobe shielding cover (that is, the first portion 1301) of the electromagnetic shielding cover 1300. With this design, a weight can be reduced without affecting performance.

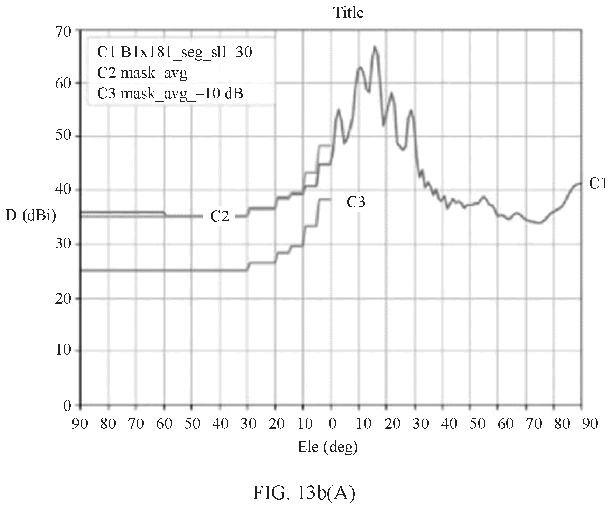

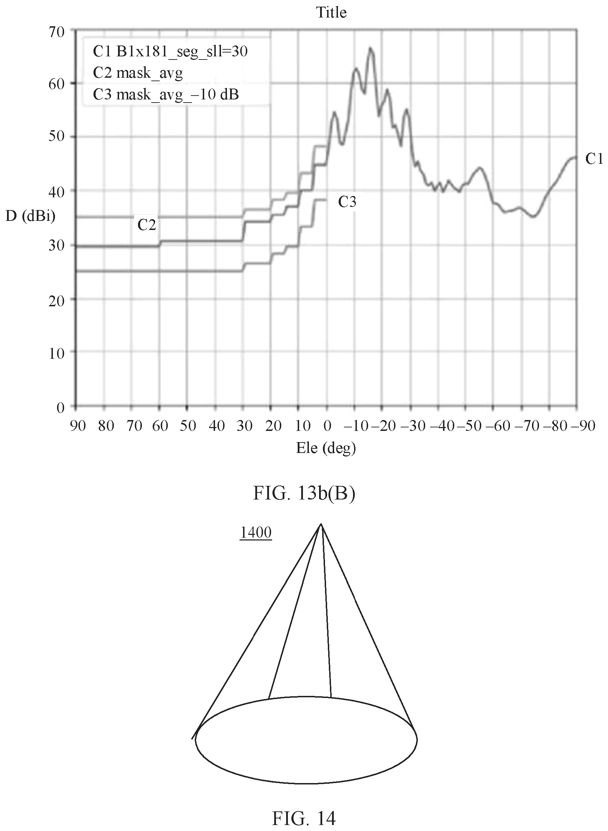

As shown in FIG. 13b(A) and FIG. 13b(B), it is found through experimental comparison between EIRP masks of an ordinary base station (FIG. 13b(A)) and a base station (FIG. 13b(B)) provided with an electromagnetic shielding cover that compared with the ordinary base station, the base station provided with the electromagnetic shielding cover achieves an improvement of appropriately 5 dB in suppression capability in far-end and middle-end angle ranges in which elevation angles of the base station in upper hemisphere are 30° to 90°, and also achieves a specific improvement in a near-end range of 0° to 30°.

The foregoing examples describe a first type of electromagnetic shielding cover provided in this application. An embodiment of this application further provides an electromagnetic shielding cover. As shown in FIG. 14, the electromagnetic shielding cover 1400 is umbrella-shaped. It may be understood that the umbrella shape may be a conventional one, or may be a polygon shape. For example, a side of the umbrella shape is straight. This is not limited in this solution. Based on the electromagnetic shielding cover 1400, energy of an upper sidelobe radiated by a base station module or a site can be shielded. For example, the electromagnetic shielding cover is referred to as an umbrella-shaped site-level electromagnetic shielding cover, or is referred to as an umbrella-shaped shielding cover.

Optionally, the electromagnetic shielding cover may be used with one or more base station modules. For example, the electromagnetic shielding cover is mounted to a site. The site includes a plurality of base station modules.

In a possible implementation, when a U6G base station is mounted at a highest location of the site, the electromagnetic shielding cover is umbrella-shaped.

In a possible implementation, a radius of an outer circle of the umbrella-shaped electromagnetic shielding cover extends to 0.5H to 1H, where H is a height of the base station module. For example, there is a specific downtilt angle between a ring and a pole. It may be understood that the pole is a metal pole for fastening the base station module, the pole may be vertically placed, and the back of the base station module is fastened to the pole through some apparatuses.

In a possible implementation, a wave-absorbing material or an EBG structure may be disposed on an outer edge of the umbrella-shaped electromagnetic shielding cover, to prevent surface wave diffraction.

In a possible implementation, a material of the electromagnetic shielding cover may be at least one of a metal plate, metalized plastic, a hollowed-out metal plate, a metal mesh, or the like.

Optionally, the material of the electromagnetic shielding cover is the metal mesh, and a grid size of the metal mesh is a preset size. The metal mesh can shield a signal in a U6G frequency band. For example, a good shielding effect can be achieved when a grid spacing of the metal mesh is less than a quarter wavelength.

In a possible implementation, a frequency selective surface (Frequency Selective Surface, FSS) technology may be used for the electromagnetic shielding cover. For example, a stopband range of an FSS is a U6G frequency band, and a passband range is an operating frequency of another base station of the site.

In this example, the umbrella-shaped electromagnetic shielding cover is used merely as an example for description, and another shape may alternatively be used, provided that the energy of the upper sidelobe radiated by the base station module or the site can be shielded.

Optionally, the umbrella-shaped electromagnetic shielding cover may be the first portion 401 (that is, the front upper sidelobe) in the embodiment shown in FIG. 4a. Because the site-level shielding cover covers a plurality of base stations at the site and has a larger size, compared with the electromagnetic shielding covers in the foregoing embodiments, the site-level shielding cover may not require a separate design of the side shielding cover and the rear lobe shielding cover.

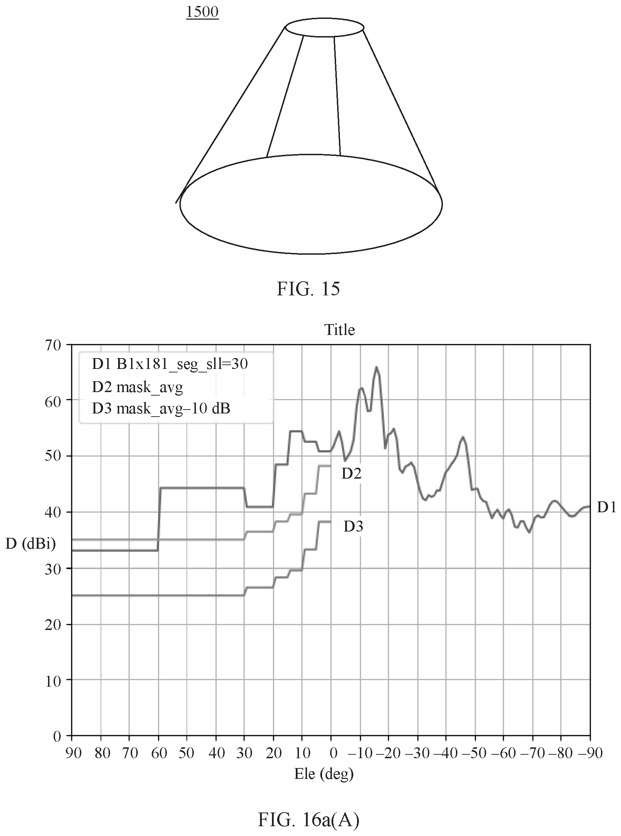

Alternatively, as shown in FIG. 15, an electromagnetic shielding cover 1500 may be annular shaped. For example, based on a mounting height of the U6G base station, when the U6G base station is mounted at a height in the middle of the site, the electromagnetic shielding cover is annular shaped.

It may be understood that the annular electromagnetic shielding cover may be independent and integrated. The annular electromagnetic shielding cover may alternatively be assembled to implement the foregoing umbrella-shaped electromagnetic shielding cover. In other words, the umbrella-shaped electromagnetic shielding cover may be integrated. The umbrella-shaped electromagnetic shielding cover may alternatively include at least two portions, where one portion is the annular electromagnetic shielding cover; and the other portion may be detachable, foldable, or the like. This is not limited in this solution.

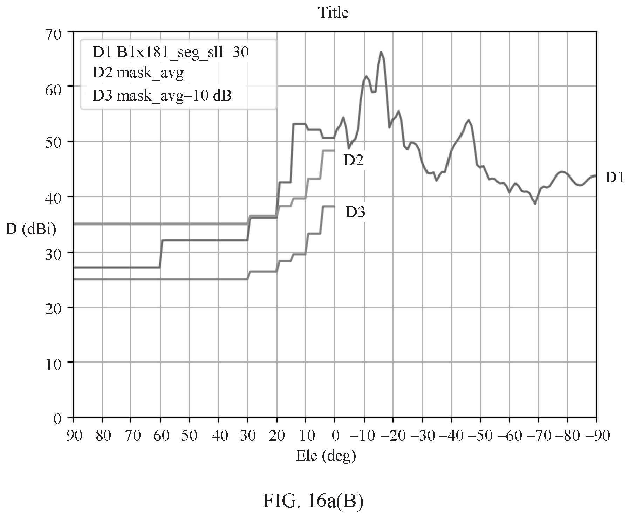

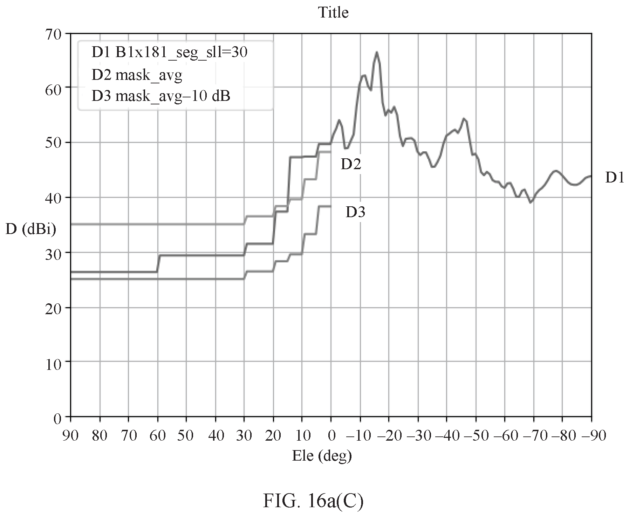

This solution resolves a problem of upper sidelobe suppression from a perspective of a physical structure, and avoids three pain points of amplitude weighting, that is, an EIRP loss in amplitude weighting, a high requirement on a degree of freedom of amplitude weighting, and a poor channel error resistance capability of amplitude weighting. FIG. 16a(A) to FIG. 16a(C) show simulation comparison of upper sidelobe suppression performance between this solution and an ordinary base station. For comparison of the upper sidelobe suppression performance between this solution and the ordinary base station, it is set that amplitude weighting is not performed on vertical units, a one-drive-three architecture is used for both this solution and the ordinary base station, and lengths of the upper sidelobe shielding cover are respectively 0H, 1H, and 2H. It may be found through comparison of average EIRP masks (as shown in FIG. 16a(A) to FIG. 16a(C)) in the three covers that this solution can provide a better suppression effect, and in particular, has a significant suppression effect on upper sidelobe energy caused by grating lobes at 30° to 60°, thereby overcoming problems of a power loss of amplitude weighting and flexibility of a radio frequency channel.

Although this solution uses a physical shielding method, and may be insensitive to a channel error, this solution can maintain a suppression effect even in a case of a large channel error. It is found in experiments that when 40 dB Taylor amplitude weighting is used for both this solution and the ordinary base station, using the Γ shielding cover of this solution results in less near-end deterioration and substantially no far-end deterioration. Conversely, both near-end and far-end suppression capabilities decrease as the error increases.

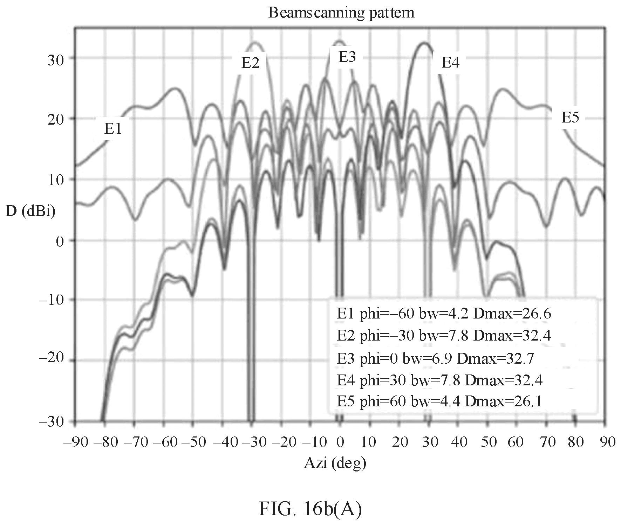

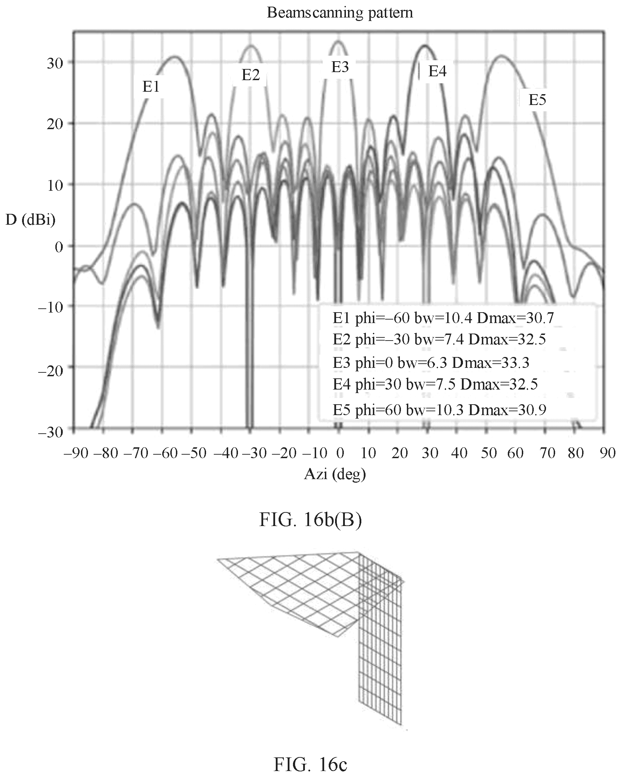

In addition, the side shielding cover of this solution also plays a key role in suppression degree improvement. It is found in the experiment that the suppression capability decreases by appropriately 5 dB if the side shielding cover is removed. However, if the side shielding cover is not chamfered, a side opening angle is small, limiting the horizontal scanning capability of the base station. With reference to FIG. 16b(A) and FIG. 16b(B), for example, when the opening angle is 30°, ±60° horizontal scanning beams are hardly formed. According to this solution, an appropriate opening angle and an appropriate cutting curve are set, so that a good suppression capability can be achieved, and excessive impact on the horizontal scanning capability and an excessively large shielding cover size can be avoided.

In addition, in this solution, the wave-absorbing material is disposed on the edge of the electromagnetic shielding cover, so that the suppression capability can be further improved. It is found in the experiment that when the size of the upper sidelobe shielding cover is H, the suppression degree achieved in the upper sidelobe angle region when the wave-absorbing material is disposed is improved by 5 dB compared with that achieved when the wave-absorbing material is not disposed.

In addition, an implementation form of the electromagnetic shielding cover in this solution may be a hollowed-out metal mesh structure, as shown in FIG. 16c. In this way, wind resistance can be reduced, and impact of the shielding cover on heat dissipation of the base station can be reduced. The grid size of the metal mesh is designed to shield signals in the U6G frequency band. Typically, a good shielding effect can be achieved when a spacing of the metal mesh is less than a quarter wavelength.

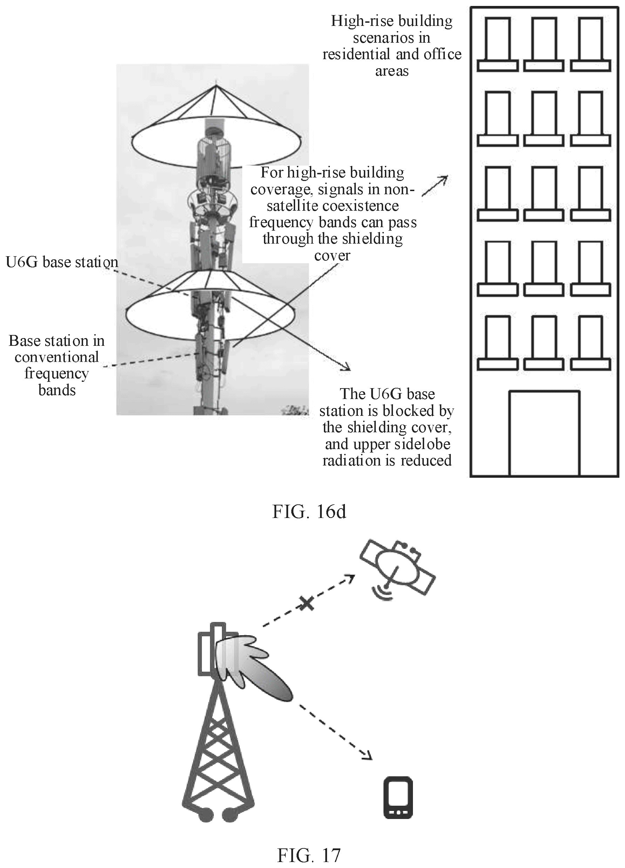

In one aspect, it is considered that base stations in a plurality of frequency bands may be mounted to a site, for example, a deployed sub-3 GHz base station. A shielding cover technology for the U6G frequency band introduced to implement satellite coexistence shall not affect base stations in original frequency bands. Especially, in a scenario requiring high-rise building coverage in FIG. 16d, a sub-3 GHz base station needs to generate an upward scanning beam to cover a user in a high-rise building, but the shielding cover may block a signal. In this scenario, a shielding cover that can transmit a sub-3 GHz signal and can suppress a U6G signal needs to be designed. The electromagnetic shielding cover designed by using the FSS in this solution can make different responses to different frequencies, so that the foregoing problems can be resolved.

This solution may be applied to a scenario in which operating frequency bands of a U6G mobile communication service and a satellite uplink service overlap. As shown in FIG. 17, according to this solution, interference caused by a base station to a satellite can be reduced by improving an upper sidelobe suppression capability, so that a mobile communication service in a new frequency band and a satellite service can coexist. It may be understood that this solution may be further applied to other scenarios other than U6G. A mobile communication technology (Integrated Mobile Telecommunications, IMT) will introduce more frequency band resources in the future, to meet requirements for a capacity, a rate, and experience, for example, a U6G frequency band (6.425 GHz to 7.125 GHz) that has been identified at the World Radiocommunication Conference (WRC-23) in 2023 and a frequency band of 7.125 GHz to 8.4 GHz that has been included in a discussion and research scope. Other services are carried in these frequency bands. Geosynchronous orbit (Geosynchronous Orbit, GSO) satellite uplink services are carried in U6G. To protect an existing service from being interfered by a newly added mobile communication service, radiation of a base station in mobile communication to the upper hemisphere needs to be limited, so that interference of the base station in mobile communication to the existing service is kept within a threshold, and the two services can coexist. This scenario is referred to as a satellite coexistence scenario. This solution may be applied to this scenario, to reduce the radiation of the base station to the upper hemisphere. It may be understood that this solution may be extended to more frequency bands in which satellite services exist. For example, medium and high frequency bands such as 10 GHz to 15 GHz are also frequency bands that may be used for mobile communication in the future. Therefore, a specific frequency band is not limited in this solution, and satellite coexistence can be implemented by using this solution for frequency bands in which satellite services exist and that may be used for mobile communication in the future.

It should be noted that in embodiments of this application, unless otherwise stated or there is a logic conflict, terms and/or descriptions between embodiments are consistent and may be mutually referenced, and technical features in different embodiments may be combined based on an internal logical relationship thereof to form a new embodiment.

It should be understood that unless otherwise specified, "/" in descriptions of this application indicates an "or" relationship between associated objects. For example, A/B may indicate A or B, where A and B may be singular or plural. In addition, in the descriptions of this application, "a plurality of" means two or more than two unless otherwise specified. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, words such as "first" and "second" are used in embodiments of this application to distinguish between same items or similar items that have basically a same function and effect. A person skilled in the art may understand that the words such as "first" and "second" do not limit a quantity and an execution sequence, and the words such as "first" and "second" do not indicate a definite difference. In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In the several embodiments provided in this application, it should be understood that the disclosed system, apparatus, and method may be implemented in other manners. For example, division into the units is merely logical function division and may be other division in an actual implementation. For example, a plurality of units or components may be combined or integrated into another system, or some features may be ignored or not performed. The displayed or discussed mutual couplings or direct couplings or communication connections may be implemented through some interfaces. The indirect couplings or the communication connections between the apparatuses or the units may be implemented in electronic, mechanical, or other forms.

The units described as separate parts may or may not be physically separate, and parts displayed as units may or may not be physical units, in other words, may be located at one position, or may be distributed on a plurality of network units. A part or all of the units may be selected based on actual requirements to achieve the objectives of the solutions of embodiments.

All or a part of the foregoing embodiments may be implemented by using software, hardware, firmware, or any combination thereof. When software is used to implement the foregoing embodiments, all or a part of the foregoing embodiments may be implemented in a form of a computer program product. The computer program product includes one or more computer instructions. When the computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium, or transmitted through the computer-readable storage medium. The computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, such as a server or a data center, integrating one or more usable media. The usable medium may be a read-only memory (read-only memory, ROM), a random access memory (random access memory, RAM), or a magnetic medium, for example, a floppy disk, a hard disk, a magnetic tape, a magnetic disk, or an optical medium, for example, a digital versatile disc (digital versatile disc, DVD), or a semiconductor medium, for example, a solid-state drive (solid-state drive, SSD).

The foregoing descriptions are merely specific implementations of embodiments of this application, but are not intended to limit the protection scope of embodiments of this application. Any variation or replacement within the technical scope disclosed in embodiments of this application shall fall within the protection scope of embodiments of this application. Therefore, the protection scope of embodiments of this application shall be subject to the protection scope of the claims.

## Claims

1. An electromagnetic shielding cover, wherein the electromagnetic shielding cover is disposed on a first side face of a base station module, the electromagnetic shielding cover is perpendicular to an antenna platform of the base station module, the electromagnetic shielding cover extends in a direction perpendicular to the antenna platform of the base station module, a height of the electromagnetic shielding cover exceeds a thickness of the base station module by a first height, energy radiated by the base station module comprises energy of a front upper sidelobe, and the electromagnetic shielding cover is configured to shield the energy of the front upper sidelobe.

2. The electromagnetic shielding cover according to claim 1, wherein the first height is related to a height of the base station module.

3. The electromagnetic shielding cover according to claim 1 or 2, wherein the electromagnetic shielding cover is further disposed in parallel with a rear face of the base station module, the energy radiated by the base station module further comprises energy of a rear upper sidelobe, and the electromagnetic shielding cover is further configured to shield the energy of the rear upper sidelobe.

4. The electromagnetic shielding cover according to any one of claims 1 to 3, wherein the electromagnetic shielding cover is further disposed on a second side face and a third side face of the base station module, the second side face and the third side face are separately connected to the first side face, the energy radiated by the base station module further comprises energy of an oblique upper sidelobe, and the electromagnetic shielding cover is further configured to shield the energy of the oblique upper sidelobe.

5. The electromagnetic shielding cover according to claim 4, wherein the electromagnetic shielding cover comprises a first portion, a second portion, and a third portion, and the first portion, the second portion, and the third portion are respectively configured to shield the energy of the front upper sidelobe, the energy of the rear upper sidelobe, and the energy of the oblique upper sidelobe.

6. The electromagnetic shielding cover according to claim 5, wherein the first portion is umbrella-shaped or annular shaped.

7. The electromagnetic shielding cover according to claim 5, wherein an outer edge of the first portion is arc-shaped.

8. The electromagnetic shielding cover according to any one of claims 7, wherein a wave-absorbing material or an electromagnetic band gap EBG structure is disposed on the outer edge of the first portion, to suppress a surface wave of the base station module.

9. The electromagnetic shielding cover according to any one of claims 5 to 8, wherein a size of the second portion is greater than or equal to a size of the base station module.

10. The electromagnetic shielding cover according to any one of claims 5 to 9, wherein the third portion has a concave curved shape.

11. The electromagnetic shielding cover according to any one of claims 1 to 10, wherein the electromagnetic shielding cover has a metal mesh structure, and a grid size of the metal mesh is a quarter wavelength; or the electromagnetic shielding cover is made based on a frequency selective surface FSS, and the FSS has a stopband covering a U6G frequency band.

12. A site, comprising the electromagnetic shielding cover according to any one of claims 1 to 11, and at least one base station module.
